# EUROPEAN PATENT SPECIFICATION

(11) **EP 3 974 937 B1**
(45) Date of publication and mention of the grant of the patent: **02.10.2024**
(21) Application number: 21186860.9
(22) Date of filing: 21.07.2021
(51) Int. Cl.: G05D 1/00

(54) **METHOD AND SYSTEM FOR DETERMINING A DESCENT PROFILE**
VERFAHREN UND SYSTEM ZUR BESTIMMUNG EINES SINKPROFILS
PROCÉDÉ ET SYSTÈME PERMETTANT DE DÉTERMINER UN PROFIL DE DESCENTE

(30) Priority: 25.09.2020 US 202017032290
(43) Date of publication of application: 30.03.2022
(73) Proprietor: GE Aviation Systems LLC, Grand Rapids, MI 49512 (US)
(72) Inventor: DARNELL, Mark, Grand Rapids, 49512 (US); RAMAKER, Russell, Grand Rapids, 49512 (US); GHAEMI, Reza, Grand Rapids, 49512 (US)
(74) Representative: Openshaw & Co.

(56) References cited:
- EP-A1- 3 203 186
- US-A1- 2012 265 374
- US-B1- 9 224 302

## Description

### STATEMENT REGARDING FEDERALLY SPONSORED RESEARCH OR DEVELOPMENT

This invention was made with government support under Contract No. DTFAWA-15-A-80013 awarded by the United States Federal Aviation Administration. The government has certain rights in the invention.

### TECHNICAL FIELD

This disclosure relates to a method and system for determining a descent profile of an aircraft.

### BACKGROUND

A flight management system (FMS) is a computer-based system on-board an aircraft that performs a number of in-flight tasks, including in-flight management according to a flight plan and performance objectives. FMSs have been in use for many years, and the programming techniques used by FMSs heretofore are designed for the computing capabilities of prior generations of computerized systems. For example, prior FMSs still in service today typically make assumptions regarding many of the complex and varied parameters regarding a flight path, including but not limited to pre-defined (i.e., constant) values for aspects regarding the aircraft and its performance characteristics and a constant value for aircraft operations such as, for example, a constant aircraft calibrated airspeed or Mach during a descent portion of flight.

US 2012/265374 A1 discloses producing a target vertical trajectory for a flight plan using aircraft performance characteristics and taking into account of the altitude constraints, but ignoring any speed and time constraints.

US 9 224 302 B1 discloses an optimised descent path considering 4D NAV. This means the descent path is optimised by also fulfilling a RTA at a waypoint.

### BRIEF DESCRIPTION

Aspects and advantages of the disclosure will be set forth in part in the following description, or may be obvious from the description, or may be learned through practice of the disclosure herein.

The invention is defined by the appended claims. Claim 1 defines a method of operating a vehicle in a descent profile and claim 11 defines a system for determining a descent profile. In the following, apparatus and/or methods referred to as embodiments that nevertheless do not fall within the scope of the claims should be understood as examples useful for understanding the invention.

The features, aspects and advantages of the disclosure herein will become better understood with reference to the following description and appended claims. The accompanying drawings, which are incorporated in and constitute a part of this specification, illustrate examples of the disclosure and, together with the description, serve to explain the principles of the disclosure herein.

### BRIEF DESCRIPTION OF THE DRAWINGS

A full and enabling disclosure of the present description, including the best mode thereof, directed to one of ordinary skill in the art, is set forth in the specification, which refers to the appended FIGS., in which:
FIG. 1 schematically illustrates a flight profile of an aircraft including a descent profile, in accordance with various aspects described herein.
FIG. 2 is a schematic view of an aircraft system that guides the flight the aircraft of FIG. 1, in accordance with various aspects described herein.
FIG. 3 schematically illustrates the descent profile of FIG. 1 in more detail, further including an optimal guidance trajectory and a position-based guidance portion in accordance with various aspects described herein.
FIG. 4 is a flow chart diagram illustrating a method of guiding a vehicle according to the descent profile of FIG. 3, with various aspects described herein.

### DETAILED DESCRIPTION

Aspects of the present disclosure can be implemented in any environment, apparatus, or method for determining or estimating a descent profile with a system regardless of the function performed by the descending device. Specifically, the descent profile can be performed through two segments of descent. The first segment of descent being defined by an optimal guidance trajectory, while the second segment of descent is defined by a positioned-based guidance. Although described in terms of an aircraft, the descent profile can be utilized by any suitable air-based vehicles (e.g. fixed wing or rotor-based, such as a helicopter).

To ensure the aircraft is operated in accordance with the descent profile, as described herein, the first segment of descent of the descent profile, specifically the portion of the descent profile operated in accordance to the optimized state trajectory, can be up-track of an initial point of the second segment of descent of the descent profile operated in accordance with the position-based guidance. As used herein, the term "track" can refer to the position of the aircraft with respect to the surface of the Earth. With that being said, the term "up-track" can refer to any position of the aircraft with respect to the surface of the Earth where the first segment of descent ends such that it is further upstream of a predetermined destination (i.e., a destination airport) than the beginning of the second segment of descent. The end of the first segment of descent being up-track of the beginning of the second segment of descent ensures the aircraft arrives at the correct altitude of the initial point of the second segment.

While "a set of" various elements will be described, it will be understood that "a set" can include any number of the respective elements, including only one element. Also, as used herein, while sensors can be described as "sensing" or "measuring" a respective value, sensing or measuring can include determining a value indicative of or related to the respective value, rather than directly sensing or measuring the value itself. The sensed or measured values can further be provided to additional components. For instance, the value can be provided to a controller module or processor, and the controller module or processor can perform processing on the value to determine a representative value or an electrical characteristic representative of said value.

All directional references (e.g. upper, lower, upward, downward, higher, lower, back, forward, above, below, vertical, horizontal, etc.) are only used for identification purposes to aid the reader's understanding of the disclosure, and do not create limitations, particularly as to the position, orientation, relative position of, or use thereof, unless otherwise stated. Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. In non-limiting examples, connections or disconnections can be selectively configured to provide, enable, disable, or the like, an electrical connection between respective elements. The exemplary drawings are for purposes of illustration only and the dimensions, positions, order and relative sizes reflected in the drawings attached hereto can vary.

As used herein, a "system" can include a "controller" or "controller module" can include a component configured or adapted to provide instruction, control, operation, or any form of communication for operable components to affect the operation thereof. A controller module can include any known processor, microcontroller, or logic device, including, but not limited to: Field Programmable Gate Arrays (FPGA), a Complex Programmable Logic Device (CPLD), an Application-Specific Integrated Circuit (ASIC), a hardware-accelerated logic controller (e.g. for encoding, decoding, transcoding, etc.), the like, or a combination thereof. Non-limiting examples of a controller module can be configured or adapted to run, operate, or otherwise execute program code to effect operational or functional outcomes, including carrying out various methods, functionality, processing tasks, calculations, comparisons, sensing or measuring of values, or the like, to enable or achieve the technical operations or operations described herein. The operation or functional outcomes can be based on one or more inputs, stored data values, sensed or measured values, true or false indications, or the like. While "program code" is described, non-limiting examples of operable or executable instruction sets can include routines, programs, objects, components, data structures, algorithms, gate arrays, etc., that have the technical effect of performing particular tasks or implement particular abstract data types. In another non-limiting example, a controller module can also include a data storage component accessible by the processor, including memory, whether transition, volatile or non-transient, or non-volatile memory. Additional non-limiting examples of the memory can include Random Access Memory (RAM), Read-Only Memory (ROM), flash memory, or one or more different types of portable electronic memory, such as discs, DVDs, CD-ROMs, flash drives, Universal Serial Bus (USB) drives, the like, or any suitable combination of these types of memory. In one example, the program code can be stored within the memory in a machine-readable format accessible by the processor. Additionally, the memory can store various data, data types, sensed or measured data values, inputs, generated or processed data, or the like, accessible by the processor in providing instruction, control, or operation to affect a functional or operable outcome, as described herein.

The present disclosure relates to determining guidance instructions, such as a flight profile, that can include nonlinear programming. As used herein, the term "nonlinear programming" is the process of solving an optimization problem defined by a system of equalities and inequalities, collectively termed "constraints," over a set of decision or control variables, along with an objective function to be maximized or minimized, where some of the constraints or the objective function are nonlinear. It is the sub-field of mathematical optimization that deals with problems that are not linear. The flight profile can further include a subset of profiles, such as a climb profile, a cruise profile, or a descent profile. The flight profile can include, or define, a flight path determined, estimated, or predicted by applying the determined control to the equations of motion given assumed initial operating states and environment conditions. In some aspects, the present disclosure particularly relates to a system and process to reduce costs parameters for a descent phase or portion of a flight path using determinations, computations, calculations, estimations, predictions, or nonlinear programming. In some aspects, nonlinear programming techniques may be leveraged to more accurately and efficiently define a flight path descent profile and generate an optimal state or control trajectory. As used herein the term "determining" refers to a determination of the system or method of an outcome or result that has occurred or is occurring (e.g. a "current" or "present" outcome or result), and contrasts with the term "prediction," which refers to a forward-looking determination or estimation that makes the outcome or result known in advance of actual performance of the occurrence.

In some aspects, nonlinear programming may be used to solve a guidance optimization problem (e.g., minimizing fuel consumption, reducing flight time, satisfying scheduling constraints, etc.) that is defined by a system of constraints over a set of unknown real variables. The use of nonlinear programming techniques and current computing capabilities in combination can provide a mechanism to address and generate a solution for the complicated nonlinear problem(s) of guidance optimization. As used herein, the term aircraft, airplane, or plane may include commercial aircraft as addressed in Title 14 of the Code of Federal Regulations part 25 (14 CFR part 25) containing rules for Airworthiness Standards: Transport Category Airplanes, drones, and other aerial vehicles.

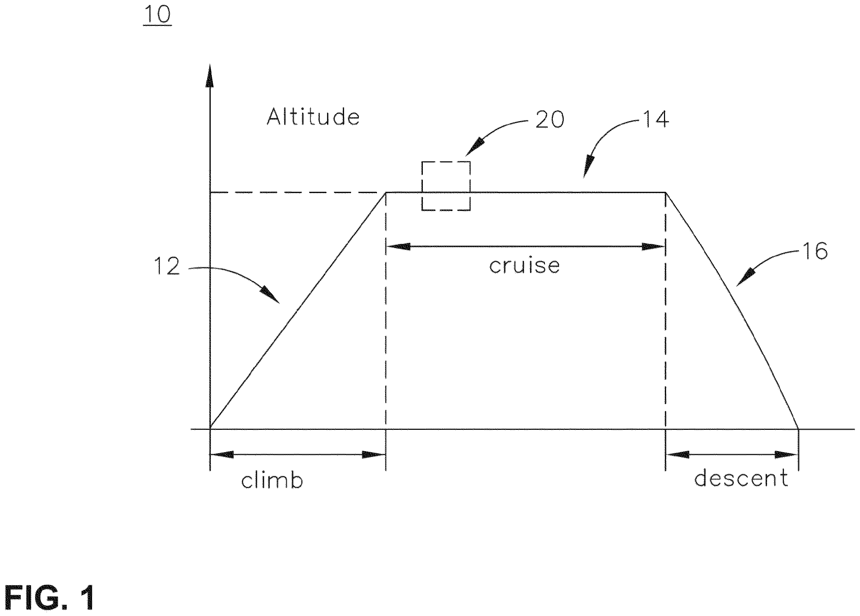

FIG. 1 illustrates a non-limiting schematic representation of a flight profile 10 such as a flight path for an aircraft 20 (shown schematically as a dotted box flying along the flight profile 10). As shown, the flight profile 10 generally includes three phases or portions, including a climb profile 12 or ascent profile, a cruise profile 14, and a descent profile 16. The graph in FIG. 1 shows the general relationship between the altitude (vertical axis) and the range of the aircraft 20 (horizontal axis). Aspects of the disclosure can include determining, estimating, or predicting an efficient descent profile 16. As used herein, an "efficient" descent profile 16 can include, but is not limited to, a descent profile 16 and that which reduces or minimizes a cost value of the descent profile 16, such as fuel consumption, descent time, rescheduling costs, or the like. Additional "costs" can be included when determining the efficient descent profile 16, or the efficiency of the descent profile. As such, aspects of this disclosure can include determining, estimating, or predicting a cost optimized descent profile 16.

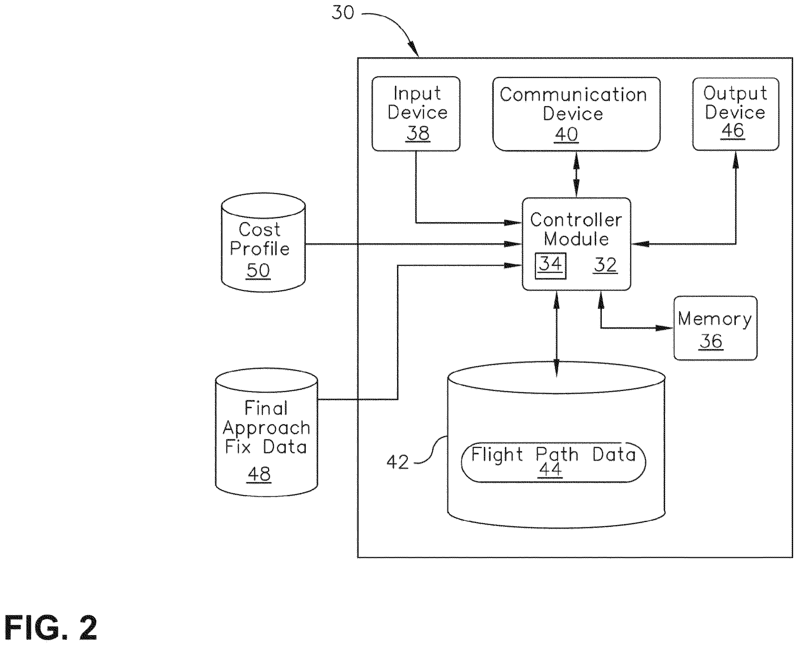

FIG. 2 illustrates a non-limiting example for a system 30 for determining the descent profile 16 of FIG. 1 including determining the descent profile 16 while the aircraft 20 is flying along or operated according to the flight profile 10. As shown, the system 30 can include a controller module 32. A processor 34 and a memory 36 can be included in, or otherwise communicatively coupled to the controller module 32. Non-limiting aspects of the system 30 can further include a set of input devices 38, a communication device 40, a set of output devices 46, and a flight profile database 42. A set of flight path data 44 can be accessible via or be included within the flight profile database 42. Non-limiting examples of the set of flight path data 44 can include calculated profile data for the flight profile 10, or portions thereof. In another non-limiting example, the set of flight path data 44 can include sets of data such as, but not limited to, previously determined or otherwise predefined data, flight profiles 10, temporarily computed data or flight profiles 10, or any combination thereof. As such, present or temporary sets of flight path data 44 can be compared with previously determined sets of flight path data 44. In another non-limiting aspect of the disclosure, the set of flight path data 44 can include parametric data related to the flight path or flight profile, or a subpart thereof. For example, the set of flight path data 44 can include various other sets of data such as, but not limited to, waypoint data, approach data, a set of performance characteristic point data, or any combination thereof. As used herein, the phrase "point data: can refer to any determined, estimated, or predicted avionic parameters such as, but not limited to, a position, airspeed, altitude, heading, or the like, for a series or sequence of points along the flight path. In another non-limiting example, the set of performance characteristic point data can further define additional characteristics of the aircraft 20 such as, but not limited to, deterioration parameters (e.g. reflecting aircraft performance characteristic changes related to the age of the aircraft, or components thereof), or personalization parameters (e.g. reflecting different configurations or components of a particular aircraft 20, such as engines, within a fleet of aircraft). In this sense, the flight path data 44 or flight profile can include a series or sequence of individual or discrete "points" or "models."

In one example, the set of input devices 38 can be adapted to provide or supply at least a set of aircraft data to the controller module 32. The set of input devices 38 can include, but are not limited to, sensors, detectors, additional systems, or the any combination thereof. The set of aircraft data can be adapted or related to aspects of the aircraft 20, present or predicted flight, and utilized for establishing, determining, estimating, or predicting aspects related to the flight path data 44. In this sense, the set of aircraft data can be utilized to inform or update current, estimated, or future flight path data 44.

The set of output devices 46 can be configured to receive data or communications of the system 30, such as a flight management system (FMS), an autopilot system, an autoflight system, an autoland system, or the like. It is contemplated that at least a portion of the system 30 can be included as a portion of the FMS, or another aircraft 20 or avionics system. The system 30 can provide at least a portion of the flight profile database 42 or flight path data 44 to another receiving device. For example, other receiving devices can include, but are not limited to, an Electronic Flight Bag (EFB), or the like. The communication device 40 can include any systems, transmitters, receivers, signal generators, or other mechanisms configured to enable communication between the system 30 and another device or system. For example, the communication device 40 can be configured to transmit or receive communications with ground-based systems, airport command and control systems, weather systems, or satellite-based systems, other aircraft, or the like. For example, the communication device 40 can be configured to receive or transmit communication with an Air Traffic Control (ATC), Airline Operations Center (AOC), or the like. In this sense, the system 30 can utilize the communication device 40 to receive additional aircraft data or communications adapted or related to aspects of the aircrafts 20 present or predicted flight path data 44, or can communicate aspects of the flight path data 44 to another device, system, or the like. As such, the communication device 40 can act or perform as an input device (similar to the set of input devices 38), and output device (similar to the set of output devices 46), or a combination thereof. As used herein, the communication device 40 can be adapted to handle digital or data transmissions (e.g. uploads or downloads) as well as analog or non-data transmissions (e.g. voice radio, etc.).

It is further contemplated that at least one of the system 30 or the controller module 32 can be communicatively coupled with a database of approach data 48 and a database of cost profile data 50. As used herein, the phrase "approach data" 48 can include data related to the final approach, or landing approach, toward a flight destination such as an airport. Approach data 48 can define a set of expected performance characteristics or avionic parameters for an aircraft 20 on final approach to land at the destination. The set of expected performance characteristics can include, but are not limited to, a set of discrete points of performance characteristics including, but not limited to, a final approach airspeed, a final approach horizontal distance (relative to the destination), a final approach altitude, heading, or the like. In one non-limiting example, the approach data 48 can be predefined by way of a set of standard performance characteristics, and stored, kept, or maintained by an accessible database, the destination (i.e., the destination airport or another respective destination), or the like.

The cost profile data 50 can include sets of data or values associated with operating, flying, maintaining, or otherwise utilizing the aircraft 20. The cost profile data 50 can be adapted to supply or provide cost or value data to the controller module 32. For example, the cost profile data 50 can include at least a set of data related to, but not limited to, fuel costs or value, fuel burn rates based on thrust, values associated with scheduling (e.g. passenger scheduling costs, or crew scheduling costs), or any combination thereof.

While the approach data 48 and the cost profile data 50 are shown remote from the system 30, non-limiting aspects of the system 30, it is contemplated that the approach data 48 and the cost profile data 50 can be included in the system 30. For example, at least a portion of the approach data 48 or the cost profile data 50 can be duplicated, copied, or stored in the memory 36 of the system 30. In another example, at least a portion of the approach data 48 or the cost profile data 50 can be received by the system 30 or memory 36 by way of a transmission provided to the communication device 40. Additionally, while the set of input devices 38, communication device 40, and the set of output devices 46 are illustrated as a portion of the system 30, non-limiting aspects of the disclosure can be included wherein the set of input devices 38, communication device 40, the set of output devices 46, or a subset thereof, are located remotely from the system 30 and communicatively connected with the system 30.

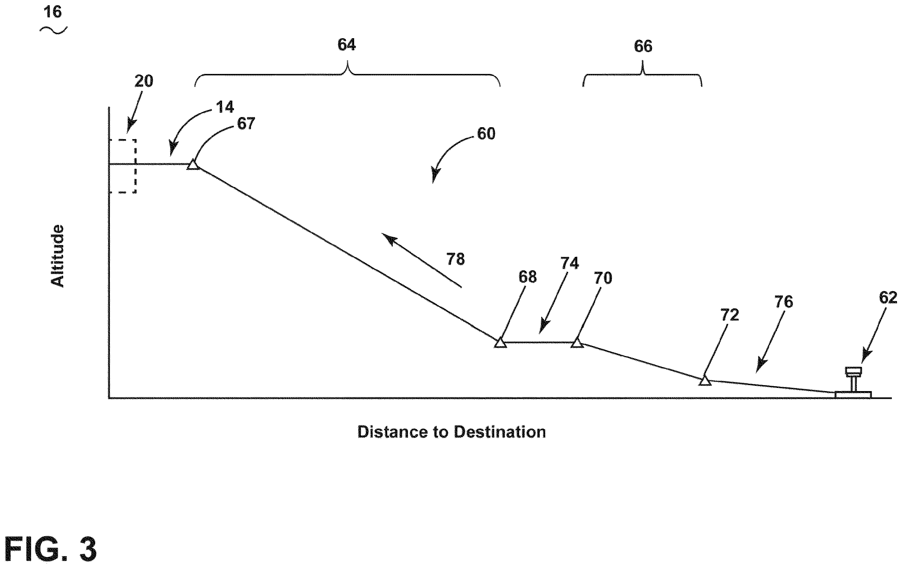

FIG. 3 illustrates the descent profile 16 of the flight profile 10 of FIG. 1. As illustrated, a limited portion of the cruise profile 14 is shown to illustrate the start of the descent profile 16 at a top of descent 67. It will be appreciated that the cruise profile 14, and hence the top of descent 67, can be at any suitable cruise altitude The descent profile 16 can include a descent trajectory 60 of the aircraft 20 descending toward the destination, illustrated as an airport 62. The descent profile 16 can include additional information related to the descent of the aircraft 20 and not illustrated by the descent trajectory 60. For example, the descent profile 16 can include cost analysis, weather interactions, timing considerations, or the like, while the descent trajectory 60 can be limited to, for instance, airspeed, heading, throttle controls, or aircraft-specific characteristics. The descent trajectory 60 can be further split into two respective sections; a first segment of descent 64 and a second segment of descent 66.

The first segment of descent 64 can refer to a section of the descent profile 16 that leads from the highest altitude or the top of descent 67 to a minimum altitude of the first segment of descent 64 that is up-track of the second segment of descent 66. As such, the point where the second segment of descent 64 ends can be defined as an up-track point 68. The first segment of descent 64 can be further defined as a portion of the descent trajectory 60 that is calculated, via the system 30 specifically via the controller module 32, to be the best optimized path or operation to get from the top of descent 67 to a point up-track of the start of the second segment of descent 66. As used herein, the phrase "best optimized" can refer to the optimization, via the system 30, for the most cost-efficient path considering various avionic parameters or performance characteristics such as, but not limited to, fuel costs, fuel level, airspeed, winds aloft, passenger comfort, idle thrust, a weight of the vehicle, or any combination thereof. As such, the first segment of descent 64 can be defined as a portion of the descent trajectory 60 in which the aircraft 20 is operated according to an optimal guidance trajectory. It will be understood that operating or calculating a cost-effective path that is mostly optimized, greatly optimized, or minimally sub-optimal is not outside the scope of the term "optimal guidance trajectory." As used herein, the term "optimal guidance trajectory" can refer to any suitable optimal open-loop control trajectory that uses a set of control variables (e.g., speed, thrust, or pitch angle of the vehicle) to optimize a cost function of the aircraft 20. Further, it will be appreciated that the term "optimal guidance trajectory" can also refer to any suitable optimal state trajectory that uses a set of state variables (e.g., speed, position, velocity, or acceleration of the vehicle) to optimize the cost function of the aircraft 20. As used herein, the term "cost function" can refer to any suitable objective function that optimizes any suitable objective of the aircraft 20 such as, but not limited to, a monetary cost, a descent time, a path angle, a maximum endurance, or a maximum range, or any combination thereof

The second segment of descent 66 can refer to a section of the descent profile 16 which beings at the initial point 70. It is contemplated that the initial point 70 can be downstream or otherwise laterally displaced from the up-track point 68 to the airport 62. Alternatively, the up-track point 68 can include the initial point 70 or otherwise be coincident with the initial point 70. In other words, the up-track point 68 and the initial point 70 can be the same point such that the end of the first segment of descent 64 and the beginning of the second segment of descent 66 are not laterally displaced, and the first segment of descent 64 can merge into the second segment of descent 66 at the up-track point 68. As used herein, the phrase "laterally displaced" refers to the distance between two positions of the aircraft 20, with respect to the airport 62, along the descent trajectory 60 that are necessarily at the same altitude. For example, the up-track point 68 can be laterally displaced farther from the airport 62 than the lateral displacement of the initial point 70 from the airport 62. In this manner, a transition region 74 can be included between the up-track point 68 and the start of the second segment of descent 66, illustrated as the initial point 70. The transition region 74 can be defined as a portion of the descent profile 16 that is down-track of the up-track point 68 and that is at a constant altitude with regards to mean sea level.

The second segment of descent 66 can be defined as a portion of the descent trajectory 60 spanning from the initial point 70 to an initial approach fix 72. During the second segment of descent 66, the aircraft 20 can be operated according to its position relative to the ground. As such, the second segment of descent 66 can be defined as a portion of the descent trajectory 60 in which the aircraft 20 is operated via position-based guidance. As used herein, the phrase "position-based guidance" refers to the operation of the aircraft 20 based on its instantaneous position relative to the descent profile (or position trajectory), which is defined relative to the surface of the Earth.

The second segment of descent 66 leads to an approach phase 76, which can be defined as a portion of the descent profile 16 spanning from the initial approach fix 72 to the airport 62. It will be understood that the second segment of descent 66 does not terminate at the airport 62, but rather terminates at the initial approach fix 72, or in other words, the beginning of the approach phase 76.

It is contemplated that the system 30 of FIG. 2 can be configured to determine, generate, calculate, or otherwise define one or more portions of the descent profile 16 or the descent trajectory 60. Including that at least a portion of the descent trajectory 60 can be defined during the flight of the aircraft 20 prior to the initiation of the first segment of descent 64. Additionally, or alternatively, portions of the descent trajectory 60 can be defined during either the first or second segment of descents 64, 66. For example, during the first segment of descent 64, a portion of the second segment of descent 66 or a down-track portion of the first segment of descent 64 (i.e., the up-track point 68) can be re-determined, re-generated, or otherwise updated by a portion of the system 30. In another non-limiting example, aspects of the system 30 can estimate or predict a future descent profile 16 or descent trajectory 60 prior to a flight occurring, or well in advance of the operating the aircraft 20 (e.g. hours, days, weeks, etc.). In another non-limiting example, the system 30 can be configured to share or distribute the determining, generating, calculating, or otherwise defining the descent profile 16 or the descent trajectory 60 between disparate or remotely located systems. For example, various external sources such as, but not limited to, the EFB, FMS, ATC, AOC, or any combination thereof can be configured to receive, transmit, generate, or otherwise perform any updates to the descent trajectory 60.

In operation, the system 30 can operably determine, predict, or estimate the descent profile 16 or the descent trajectory 60 by starting with the second segment of descent 66 operated through the position-based guidance, which is predetermined. More specifically, the system 30 back-calculates the first segment of descent 64 of the descent profile 16 or descent trajectory 60 upward along the descent profile 16 (e.g. back-calculating the first segment of descent 64 at a variable distance away from the airport 62). As used herein, the "upward" direction along the descent profile 16 is represented with the arrow or upward direction 78. The system 30 operates to back-calculate the first segment of descent 64 in the upward direction 78 by solving or calculating performance characteristics of a subsequent portion of the first segment of descent 64 based on an immediately preceding portion of the first segment of descent 64. "Preceding" in this description refers to a direction opposite the upward direction 78.

As such, the aircraft 20 receives or otherwise generates, via the system 30, the second segment of descent 66. It will be appreciated that the second segment of descent 66 can be back-calculated, via the system 30, from the airport 62 or the initial approach fix 72 to the initial point 70. The second segment of descent 66 can either include or otherwise generate aircraft 20 performance characteristics based on the approach- data 48, the system 30 can subsequently back-calculate the first segment of descent 64, in the upward direction 78 from the second segment of descent 66.

Each back-calculation of the first segment of descent 64 can solve for one or more avionic parameters, including but not limited to airspeed or variable thrust parameter controls. In one non-limiting aspect, the avionic parameters solved, via the system 30, can be optimized according at least in part due to a function of the aircraft 20 (e.g., the cost function), such as solving for variable thrust controls that are different from or greater than idle thrust control values (e.g. performance characteristics of thrust greater than zero or partial thrust). It is further contemplated, variable thrust controls can be constrained or otherwise limited only during a portion of the descent profile 16, such as during the first half of the descent profile 16. In this instance, the first "half' of the descent profile 16 can be defined by altitude, time, the like, or a combination thereof. As used herein, "variable thrust controls", or the like, refer to settings, inputs, control system responses, or the like enable or configured to adjust a thrust or thrust output for an aircraft 20 or aircraft engine. For example, variable thrust controls can include engine control settings or parameters, fuel consumption settings or parameters, or the like. In another non-limiting example, variable thrust controls can include a combination of settings or parameters enabling the thrust or thrust output.

As discussed herein, the first segment of descent 64 and hence each back-calculation of the first segment of descent 64 can be at least partially based on cost values or cost parameters defined by the cost profile data 50. For instance, avionic parameters can include airspeed or variable thrust controls, based on minimizing costs or values defined by the cost profile data 50. As such, the back-calculations of the first segment of descent 64 can create the optimal guidance trajectory of the aircraft 20 from the cruise profile 14 to, at least, the up-track point 68.

It is contemplated that the optimal guidance trajectory of the first segment of descent 64 is the outcome of the variable speed, variable thrust control that minimizes at least one cost function of the aircraft 20. Specifically, the optimal guidance trajectory of the first segment can minimize a Direct Operating Cost (DOC) of the aircraft 20. The DOC can refer to the specific cost required for the aircraft 20 to execute at least a portion of the during the descent of the aircraft 20 (e.g., the DOC of the first segment of descent 64). The vertical position of the vehicle is not controlled during this part of the descent. However, the optimal guidance trajectory is predicted according to the speed and thrust control history and the estimated vehicle weight and winds aloft. Thus, the optimal guidance trajectory of the first segment of descent 64 is an estimate. The optimal guidance trajectory can be predicted as described herein to ensure a situational awareness of the aircraft 20 along the optimal guidance trajectory. As used herein, the phrase "situational awareness" can refer to the ability of the flight crew or pilot to be able to see the various avionic characteristics of the aircraft 20 along the optimal guidance trajectory. In other words, the prediction of the first segment of descent 64 can generate a set of predicted avionic characteristics (e.g., a predicted altitude or a predicted speed). The set of predicted avionic characteristics can be accessed or otherwise viewed by one or more of the pilot or the flight crew such that the pilot or flight crew can easily see the predicted avionic characteristics at downstream portions of the optimal guidance trajectory. The optimal guidance trajectory can be predicted to further ensure the aircraft 20 is at a target altitude when it reaches the up-track point 68 which is necessarily the same altitude as the initial point 70 of the second segment of descent 66. It is further contemplated that the optimal guidance trajectory can be predicted to ensure that the initial point of descent is coincident with the top of descent 67. In other words, as the first segment of descent 64 is back-calculated from the up-track point 68, it is important to ensure the calculated initial point of descent is the same as the top of descent 67. The optimal guidance trajectory can yet further be predicted to find the most cost-optimal thrust and airspeed that can minimize the DOC of the aircraft 20.

It is further contemplated that the system 30 can also solve for the one or more avionic parameters by first calculating a threshold value along at least a portion of the first segment of descent 64. For example, the threshold value can be, but is not limited to, an aircraft energy value, that is, the total or summation of an actual, an estimated, a predicted, or an arbitrary amount of potential and kinetic energy of the aircraft 20 at a corresponding portion along the first segment of descent 64. Additionally, or alternatively, by knowing or having previously calculated a preceding portion of the first segment of descent 64, the subsequent back-calculating of another portion of the first segment of descent 64 can be at least partially based on, for instance, an actual, an estimated, a predicted, or a determined airspeed or thrust control of the aircraft 20 (e.g. values that will be related to the kinetic energy of the aircraft 20). It is further contemplated that the subsequent back-calculating of the first segment of descent 64 can be at least partially based on a subset of the airspeed, thrust control, altitude, or any other performance characteristic defined or calculated in the preceding portion of the first segment of descent 64. The subsequent back-calculating can further be based on additional state information of the aircraft 20 or environment, such as data received by the set of input devices 38 or communication device 40, and including but not limited to atmospheric information, flight path constraints, vehicle constraints, airport traffic, weather models, or the like.

The repeated back-calculating at finite intervals of the first segment of descent can be further based on successively larger or higher aircraft 20 energy levels, wherein the energy levels are successively larger or higher due to higher altitudes and higher airspeed or thrust controls as first segment of descent 64 moves in the upward direction 78. Non-limiting examples of successively larger or higher aircraft 20 energy levels can be based on predetermined, determined, calculated, actual, estimated, predicted, or arbitrary increases in energy levels. In one non-limiting example, the repeated back-calculating can stop or cease when the back-calculating reaches, meets, exceeds, or satisfies a current performance characteristic of the aircraft 20 (e.g. the current altitude, current airspeed, or a combination thereof), as sensed or measured by the system 30 (e.g. by way of the set of input devices 38 or the communication device 40). Alternatively, the repeated back-calculating can stop or cease when the back-calculating reaches, meets, exceeds, or satisfies the cruise profile 14.

Many other possible aspects and configurations in addition to that shown and described are contemplated by the present disclosure. For example, one aspect of the disclosure contemplates that the system 30 can calculate, estimate, or predict aircraft operating characteristics of the descent profile 16 or descent trajectory 60 along the first segment of descent 64. Another aspect of the disclosure contemplates the system 30 can also determine the descent profile 16 based at least partially on determined, calculated, estimated, or predicted weight of the aircraft 20. For example, the system 30 can estimate or predict an aircraft 20 weight at the estimated or predicted initial descent point of the descent profile 16, based on, for example, a fuel burn rate, which affects weight of the aircraft 20, the cruise profile 14, the overall flight profile 10 or current flight plan, an estimated horizontal distance of the aircraft 20 at the initial descent point, the like, or a combination thereof. The system 30 can then perform the repeated back-calculating, as described herein. Once the system 30 determines or predicts the descent profile 16, the system 30 can further determine or predict an aircraft weight based on cruise profile 14, the horizontal distance of the descent profile 16, and the descent profile 16 performance characteristics such as the variable thrust controls. The system 30 can then compare the estimated or predicted aircraft weight at the initial descent point with the back-calculated estimated or predicted aircraft weight of the descent profile 16, and upon satisfying the comparison (e.g. the comparison is outside of a value, range, threshold, or tolerance), repeating the process to determine or predict a new descent profile 16 by repeatedly back-calculating a new first segment of descent 64 utilizing an updated prediction or estimation of the aircraft weight at the initial descent point.

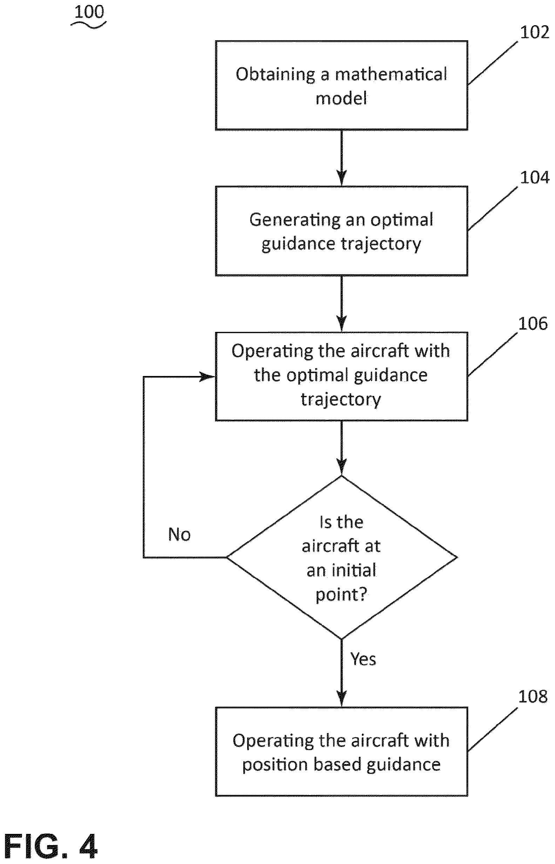

FIG. 4 illustrates a non-limiting example method 100 of operating the aircraft 20 in the descent profile 16 of FIG. 3. It will be appreciated that although described in terms of the aircraft 20, it will be appreciated that the method 100 can be applied to the descent of any suitable vehicle as described herein. It will be further appreciated that although various portions of method 100 are described in terms of being done "at the controller module 32", that the portions of the method 100 can instead be performed "at any suitable device" accessible to the vehicle. For example, in terms of the aircraft 20, any suitable device can be, but is not limited to, the EFB, FMS, AOC, ATC, or any combination thereof.

The method 100 can begin by obtaining, at the controller module 32, a mathematical model for the aircraft 20, at 102. Specifically, the mathematical model can be defined as a representation of one or more performance characteristics or avionic parameters for the aircraft 20. In other words, the mathematical model can be the model of the motion of the aircraft 20 from the top of descent 67 to a target altitude (i.e., the up-track point 68 or the initial point 70). The optimal guidance trajectory can then be generated, via the controller module 32, for the first segment of descent 64, at 104. The optimal guidance trajectory can be parameterized by a variable monotonically decreasing with the altitude. The optimized state trajectory can, for example, be a portion of the descent trajectory 60 which monotonically decreases toward a target altitude (i.e., the up-track point 68 or the initial point 70). The optimized state trajectory can be monotonically decreasing such that the altitude parameter or target altitude is satisfied at the end of the first segment of descent 64. In other words, the altitude parameter can include the optimal guidance trajectory beginning at the top of descent 67 and ending at a minimum altitude that is up-track (i.e., the up-track point 68) the initial point 70 of the position-based guidance of the second segment of descent 66. It is further contemplated that the vertical distance between the top of descent 67 and the up-track point 68 can be divided into a finite number of uniform intervals. Once the optimized state trajectory is generated, the aircraft 20 can be operated in accordance with the optimal guidance trajectory, at 106. This operation of the aircraft 20 according to the optimal guidance trajectory can occur until the altitude parameter is satisfied. Once satisfied and the aircraft 20 is at the initial point 70, the aircraft 20 can then be operated according to the position-based trajectory, at 108. It will be appreciated that the aircraft 20 can be operated according to the position-based trajectory at a point that is down-track, downstream, or exactly at the up-track point 68 (the end of the operation of the aircraft 20 according to the optimized state trajectory). If the aircraft 20, however, is not at the initial point 70, the aircraft 20 will continue to be operated in accordance with the optimal guidance trajectory until the initial point 70 is reached. It will be appreciated that the operation of the aircraft 20 can be performed by at last one of a pilot or autopilot tracking the optimal control input generated by the system 30 (e.g., the FMS).

The sequences depicted in method 100 is for illustrative purposes only and is not meant to limit the method 100 in any way as it is understood that the portions of the method can proceed in a different logical order, additional or intervening portions can be included, or described portions of the method can be divided into multiple portions, or described portions of the method can be omitted without detracting from the described method.

In one non-limiting example, the mathematical model can be calculated through use of back-calculating the first segment of descent 64 from the second segment of descent 66. Additionally, or alternatively, the vehicle motion, or the mathematical model can be derived from a set of differential algebraic equations. As such, the mathematical model can include or otherwise be derived from a set of state variables. The set of state variables can be defined as a set of avionic parameters relating to the operation of the aircraft 20 such as, but not limited to, aerodynamics of the vehicle, thrust forces, moments, the mass of the aircraft, the thrust, or any combination thereof. It is further contemplated that once the mathematical model is obtained, at 102, a set of fast dynamic state variables can be eliminated in the mathematical model to create a reduced-order mathematical model. As used herein, fast dynamic state variables can refer to various avionic parameters or state variables which have a negligible effect on fuel consumption of the aircraft 20. For example, an angle of attack or elevator deflection of the aircraft 20 can be considered a fast-dynamic state variable which can be eliminated to generate the reduced-order mathematical model. The generating of the optimal guidance trajectory can then be based off of and otherwise generated through, at 104, the reduced-order mathematical model.

In another non-limiting example, the generating of the optimal guidance trajectory generated, at 104, can further include calculating a velocity along the optimal guidance trajectory for the mathematical model as a control variable. With velocity being selected as the control variable, a Hamiltonian function can be defined as a directed operating cost per energy unit. It is further contemplated that the generating of the optimal guidance trajectory generated, at 104, can further include a parameterization of one or more variable intervals to solve for at least a portion of the mathematical model, specifically a Hamiltonian function of the mathematical model. The variable intervals can include, but are not limited to, an energy interval, an altitude interval, or a time interval. For example, in other words, the path of the optimal guidance trajectory can be found by generating a set of parametric equations, via the system 30, which can be found, or otherwise solved through the parametrization of the energy intervals during the descent of the aircraft 20.

In yet another non-limiting example, the generating of the optimal guidance trajectory, at 104, can further include a cost analysis based off the performance characteristics or avionic parameters. The cost analysis can be done through the methods described herein. Specifically, the cost analysis can be done by back-calculating the second segment of descent 64 through the methods as described herein, and utilizing at least a portion of the cost profile data 50 in the generation of the optimal guidance trajectory.

In another non-limiting example, the method 100 can further include checking, via the system 30, that the optimal guidance trajectory generated, at 104, complies with a set of airspace constraints. In other words, the optimal guidance trajectory can be compared, via the system 30, with a set of known or received airspace constraints to ensure the optimal guidance trajectory does not interfere with one or more airspace constraint included within the set of airspace constraints. The set of airspace constraints can include, but are not limited to, an altitude of the vehicle, a speed of the vehicle, or any combination thereof. The admissible control is constrained such that each portion of the descent trajectory 60 complies with altitude and speed restricts that are specific to the airspace. Altitude and speed restrictions can require, for example, a constant altitude during one or more portions of the descent trajectory 60. As such, it will be appreciated that the descent trajectory 60 as illustrated herein is a schematic representation of the descent trajectory 60. In other words, the descent trajectory 60 can be defined as monotonically decreasing from the top of descent 67 to the initial approach fix 72. For example, a portion of the first segment of descent 64 can include a portion where the aircraft 20 is at a differing rate of change in altitude when compared to other portions of the first segment of descent 64 (e.g., a portion of the first segment of descent can be constant).

The aspects disclosed herein provide a method and system for determining or predicting a descent profile. The technical effect is that the above described aspects enable the determining, predicting, or otherwise generation of a descent profile to be flown by an aircraft. One advantage that can be realized in the above aspects is that the above described aspects reduce flight operation costs during the descent phase of the aircraft. The costs can be measured in time, scheduling, fuel consumption, or other aspects captured by the cost profile data 50. Another advantage of the disclosure can include a smoother transition to the descent profile from the cruise profile, improving passenger ride quality.

It is contemplated that aspects of this disclosure can be advantageous for use over conventional systems or methods for operating a vehicle during descent. For example, conventional systems and methods can create a descent trajectory that only includes the position-based guidance (e.g., a glidepath) that approximates the optimal state trajectory based on perfect equations of motion, the vehicle weight, and other parameters (e.g., winds aloft). Relying solely on position-based guidance presents various challenges such as, but not limited to, a complexity in tracking an idle or otherwise constant thrust descent trajectory that does not account for the effect of vehicle weight and other parameters (e.g., winds aloft). As such, the conventional systems and methods can result in a descent trajectory that is not the most cost-optimized descent and, in some instances, misses a target point (e.g., the aircraft ends up-track of a targeted position) of the descent trajectory. The method and systems described herein, however, relies on a two-segment approach (e.g., the optimal guidance trajectory that transitions into the position-based guidance). The two-segment approach can be used to generate the most cost optimal descent trajectory while ensuring that the altitude of the end-point of the optimal guidance trajectory is equal to the altitude of the initial point of the position-based guidance portion of the descent trajectory. The generation of the optimal guidance trajectory can include, at least, a cost analysis to ensure the path taken from the top of descent to the initial point of the position-based guidance is the most cost-optimal and suitable path for the vehicle to take. The generation of the optimal guidance trajectory and the operation of the vehicle according to the optimal guidance trajectory can be done with minimal intervention from the operator of the vehicle. In other words, the methods and system described herein do not require intensive intervention from the operator of the vehicle as the optimal descent trajectory can be generated automatically (without need for manual operator intervention), and once the optimal guidance trajectory is generated automatically, the operator can engage an auto-thrust or auto-pilot control such that the vehicle can be operated according to the optimal guidance trajectory, which was generated to be the most cost optimal descent trajectory.. The optimal guidance trajectory can be further defined as a segment of descent executed through the variable speed and variable thrust control of the vehicle that minimizes the DOC of the vehicle during descent when compared to conventional methods of descent for a vehicle. Further, the optimal guidance trajectory is generated such that there is the transition region between the up-track point and the initial point, or such that the up-track point and the initial point are the same point. In other words, the optimal guidance trajectory is generated such that the up-track point is never down-track of the initial point. This ensures that the vehicle does not overshoot the initial point before ending the optimal guidance trajectory (and thus the vehicle is at the correct altitude when the vehicle transits the initial point). This ultimately further increases the advantages of the methods and systems described herein over conventional systems or methods for operating a vehicle during descent as the use of the two-segment approach ensures that the first segment will never end down track the initial point of the second segment.- Thus, ensuring the methods and systems described herein for generating a descent trajectory that best approximates or otherwise generates an optimum trajectory (e.g., the most cost efficient descent trajectory) or the most cost optimized descent profile are advantageous over conventional systems or methods for operating a vehicle during descent.

To the extent not already described, the different features and structures of the various aspects can be used in combination with each other as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

This written description uses examples to disclose aspects of the disclosure, including the best mode, and also to enable any person skilled in the art to practice aspects of the disclosure, including making and using any devices or systems and performing any incorporated methods. The patentable scope of the disclosure is defined by the claims, and can include other examples that occur to those skilled in the art. Such other examples are intended to be within the scope of the claims if they have structural elements that do not differ from the literal language of the claims.

## Claims

1. A method (100) of operating a vehicle in a descent profile (16), the method (100) comprising:
obtaining (102), at a controller module (32), a mathematical model of performance characteristics for an aircraft (20);
generating (104) an optimal guidance trajectory, for at least a first segment of descent (64), based on the mathematical model; and
operating (106) the aircraft (20) in accordance with the optimal guidance trajectory prior to operating in a position-based guidance during a second segment of descent (66), which begins at an initial point (70), wherein operating the aircraft in the position-based guidance comprises operating the aircraft based on an instantaneous position of the aircraft relative to the descent profile;
wherein the generating (104) of the optimal guidance trajectory comprises calculating a speed along the optimal guidance trajectory for the mathematical model as a control variable,
wherein the generating (104) of the optimal guidance trajectory further comprises performing a cost analysis based on the performance characteristics, and
wherein the optimal guidance trajectory is monotonically decreasing and ends at a minimum altitude (68) that is up-track of the initial point (70) of the position-based guidance.

2. The method (100) of claim 1, further comprising eliminating fast dynamic state variables in the mathematical model to create a reduced-order mathematical model and wherein the generating (104) is based on the reduced-order mathematical model.

3. The method (100) of any of claims 1 or 2 wherein the mathematical model is of the aircrafts (20) motion during the descent profile (16).

4. The method (100) of any of claims 1-3 wherein the mathematical model includes mass as a state variable.

5. The method (100) of any of claims 1-4 wherein the generating (104) of the optimal guidance trajectory further comprises a parameterization of energy intervals for the mathematical model.

6. The method (100) of any of claims 1-5 wherein the generating (104) of the optimal guidance trajectory further comprises a parameterization of altitude intervals for the mathematical model.

7. The method (100) of any of claims 1-6 wherein the determining of the optimal guidance trajectory starts at a prescribed top of descent (67).

8. The method (100) of any of claims 1-7 wherein the performance characteristics are one or more of an idle thrust, a weight of the vehicle, and or a winds aloft.

9. The method (100) of any of claims 1-8 further comprising checking, via the controller module (32), that the optimal guidance trajectory complies with a set of airspace constraints.

10. The method (100) of claim 9 wherein the set of airspace constraints are one or more of an altitude or a vehicle speed.

11. A system for determining a descent profile (16), the system comprising:
memory (36) storing aircraft (20) performance characteristics;
a controller module (32) configured to perform the steps of:
obtaining (102) a mathematical model of performance characteristics for an aircraft (20);
generating (104) an optimal guidance trajectory, for at least a first segment of descent (64), based on the mathematical model; and
operating (106) the aircraft (20) in accordance with the optimal guidance trajectory prior to operating in a position-based guidance during a second segment of descent (66), which begins at an initial point (70), wherein operating the aircraft in the position-based guidance comprises operating the aircraft based on an instantaneous position of the aircraft relative to the descent profile;
wherein the generating (104) of the optimal guidance trajectory comprises calculating a speed along the optimal guidance trajectory for the mathematical model as a control variable,
wherein the generating (104) of the optimal guidance trajectory further comprises performing a cost analysis based on the performance characteristics, and
wherein the optimal guidance trajectory is monotonically decreasing and ends at a minimum altitude (68) that is up-track of the initial point (70) of the position-based guidance.

## Patentansprüche

1. Verfahren (100) zum Betreiben eines Fahrzeugs in einem Sinkflugprofil (16), wobei das Verfahren (100) umfasst:
Erhalten (102), an einem Steuermodul (32), eines mathematischen Modells von Leistungseigenschaften für ein Luftfahrzeug (20);
Erzeugen (104) einer optimalen Führungstrajektorie für mindestens einen ersten Sinkflugabschnitt (64) auf der Grundlage des mathematischen Modells; und
Betreiben (106) des Luftfahrzeugs (20) gemäß der optimalen Führungsflugbahn vor dem Betreiben in einer positionsbasierten Führung während eines zweiten Sinkflugabschnitts (66), der an einem Anfangspunkt (70) beginnt, wobei das Betreiben des Luftfahrzeugs in der positionsbasierten Führung das Betreiben des Luftfahrzeugs basierend auf einer momentanen Position des Luftfahrzeugs relativ zum Sinkflugprofil umfasst;
wobei das Erzeugen (104) der optimalen Führungstrajektorie das Berechnen einer Geschwindigkeit entlang der optimalen Führungstrajektorie für das mathematische Modell als Steuervariable umfasst,
wobei das Erzeugen (104) der optimalen Führungstrajektorie ferner das Durchführen einer Kostenanalyse auf der Grundlage der Leistungseigenschaften umfasst, und
wobei die optimale Führungstrajektorie monoton abnimmt und bei einer Mindesthöhe (68) endet, die oberhalb des Anfangspunkts (70) der positionsbasierten Führung liegt.

2. Verfahren (100) nach Anspruch 1, ferner umfassend das Eliminieren schneller dynamischer Zustandsvariablen im mathematischen Modell, um ein mathematisches Modell reduzierter Ordnung zu erstellen, und wobei das Generieren (104) auf dem mathematischen Modell reduzierter Ordnung basiert.

3. Verfahren (100) nach einem der Ansprüche 1 oder 2, wobei das mathematische Modell die Bewegung des Luftfahrzeugs (20) während des Sinkflugprofils (16) darstellt.

4. Verfahren (100) nach einem der Ansprüche 1 bis 3, wobei das mathematische Modell Masse als eine Zustandsvariable einschließt.

5. Verfahren (100) nach einem der Ansprüche 1 bis 4, wobei das Erzeugen (104) der optimalen Führungstrajektorie ferner eine Parametrisierung von Energieintervallen für das mathematische Modell umfasst.

6. Verfahren (100) nach einem der Ansprüche 1 bis 5, wobei das Erzeugen (104) der optimalen Führungstrajektorie ferner eine Parametrisierung von Höhenintervallen für das mathematische Modell umfasst.

7. Das Verfahren (100) nach einem der Ansprüche 1 bis 6, wobei das Bestimmen der optimalen Führungstrajektorie an einem vorgeschriebenen obersten Sinkflugpunkt (67) beginnt.

8. Verfahren (100) nach einem der Ansprüche 1 bis 7, wobei die Leistungseigenschaften ein oder mehrere von einem Leerlaufschub, einem Gewicht des Fahrzeugs und/oder einem Höhenwind sind.

9. Verfahren (100) nach einem der Ansprüche 1 bis 8, ferner umfassend das Überprüfen, über das Steuermodul (32), ob die optimale Führungstrajektorie einer Reihe von Luftraumbeschränkungen entspricht.

10. Verfahren (100) nach Anspruch 9, wobei die Menge der Luftraumbeschränkungen eine oder mehrere von einer Höhe oder einer Fahrzeuggeschwindigkeit sind.

11. System zum Bestimmen eines Sinkflugprofils (16), wobei das System umfasst:
Speicher (36), der Leistungseigenschaften des Luftfahrzeugs (20) speichert;
ein Steuermodul (32), das konfiguriert ist, um die folgenden Schritte auszuführen:
Erhalten (102) eines mathematischen Modells von Leistungseigenschaften für ein Luftfahrzeug (20);
Erzeugen (104) einer optimalen Führungstrajektorie für mindestens einen ersten Sinkflugabschnitt (64) auf der Grundlage des mathematischen Modells; und
Betreiben (106) des Luftfahrzeugs (20) gemäß der optimalen Führungsflugbahn vor dem Betreiben in einer positionsbasierten Führung während eines zweiten Sinkflugabschnitts (66), der an einem Anfangspunkt (70) beginnt, wobei das Betreiben des Luftfahrzeugs in der positionsbasierten Führung das Betreiben des Luftfahrzeugs basierend auf einer momentanen Position des Luftfahrzeugs relativ zum Sinkflugprofil umfasst;
wobei das Erzeugen (104) der optimalen Führungstrajektorie das Berechnen einer Geschwindigkeit entlang der optimalen Führungstrajektorie für das mathematische Modell als Steuervariable umfasst,
wobei das Erzeugen (104) der optimalen Führungstrajektorie ferner das Durchführen einer Kostenanalyse auf der Grundlage der Leistungseigenschaften umfasst, und
wobei die optimale Führungstrajektorie monoton abnimmt und bei einer Mindesthöhe (68) endet, die oberhalb des Anfangspunkts (70) der positionsbasierten Führung liegt.

## Revendications

1. Procédé (100) de fonctionnement d'un véhicule dans un profil de descente (16), le procédé (100) comprenant :
l'obtention (102), au niveau d'un module de dispositif de commande (32), d'un modèle mathématique des caractéristiques de performance pour un aéronef (20) ;
la génération (104) d'une trajectoire de guidage optimale, pour au moins un premier segment de descente (64), sur la base du modèle mathématique ; et
le fonctionnement (106) de l'aéronef (20) conformément à la trajectoire de guidage optimale avant le fonctionnement dans un guidage basé sur la position au cours d'un second segment de descente (66), qui commence à un point initial (70), dans lequel le fonctionnement de l'aéronef dans le guidage basé sur la position comprend le fonctionnement de l'aéronef sur la base d'une position instantanée de l'aéronef par rapport au profil de descente ;
dans lequel la génération (104) de la trajectoire de guidage optimale comprend le calcul d'une vitesse le long de la trajectoire de guidage optimale pour le modèle mathématique en tant que variable de commande,
dans lequel la génération (104) de la trajectoire de guidage optimale comprend en outre la réalisation d'une analyse des coûts sur la base des caractéristiques de performance, et
dans lequel la trajectoire de guidage optimale diminue de façon monotone et se termine à une altitude minimale (68) supérieure à la route du point initial (70) du guidage basé sur la position.

2. Procédé (100) selon la revendication 1, comprenant en outre l'élimination des variables d'état dynamiques rapides dans le modèle mathématique pour créer un modèle mathématique d'ordre réduit et dans lequel la génération (104) est basée sur le modèle mathématique d'ordre réduit.

3. Procédé (100) selon l'une quelconque des revendications 1 ou 2, dans lequel le modèle mathématique est celui du mouvement des avions (20) pendant le profil de descente (16).

4. Procédé (100) selon l'une quelconque des revendications 1 à 3, dans lequel le modèle mathématique comporte une masse en tant que variable d'état.

5. Procédé (100) selon l'une quelconque des revendications 1 à 4, dans lequel la génération (104) de la trajectoire de guidage optimale comprend en outre une paramétrisation des intervalles d'énergie pour le modèle mathématique.

6. Procédé (100) selon l'une quelconque des revendications 1 à 5, dans lequel la génération (104) de la trajectoire de guidage optimale comprend en outre une paramétrisation des intervalles d'altitude pour le modèle mathématique.

7. Procédé (100) selon l'une quelconque des revendications 1 à 6, dans lequel la détermination de la trajectoire de guidage optimale commence à un sommet de descente prescrit (67).

8. Procédé (100) selon l'une quelconque des revendications 1 à 7, dans lequel les caractéristiques de performance sont une ou plusieurs parmi une poussée de ralenti, un poids du véhicule, ou des vents en altitude.

9. Procédé (100) selon l'une quelconque des revendications 1 à 8 comprenant en outre le fait de vérifier, par l'intermédiaire du module de dispositif de commande (32), que la trajectoire de guidage optimale est conforme à un ensemble de contraintes d'espace aérien.

10. Procédé (100) selon la revendication 9, dans lequel l'ensemble des contraintes d'espace aérien sont une ou plusieurs parmi une altitude ou une vitesse de véhicule.

11. Système de détermination d'un profil de descente (16), le système comprenant :
une mémoire (36) stockant des caractéristiques de performance de l'aéronef (20) ;
un module de dispositif de commande (32) configuré pour réaliser les étapes consistant à :
obtenir (102) un modèle mathématique des caractéristiques de performance pour un aéronef (20) ;
générer (104) une trajectoire de guidage optimale, pour au moins un premier segment de descente (64), sur la base du modèle mathématique ; et
faire fonctionner (106) l'aéronef (20) conformément à la trajectoire de guidage optimale avant de le faire fonctionner dans un guidage basé sur la position au cours d'un second segment de descente (66), qui commence à un point initial (70), dans lequel le fonctionnement de l'aéronef dans le guidage basé sur la position comprend le fonctionnement de l'aéronef sur la base d'une position instantanée de l'aéronef par rapport au profil de descente ;
dans lequel la génération (104) de la trajectoire de guidage optimale comprend le calcul d'une vitesse le long de la trajectoire de guidage optimale pour le modèle mathématique en tant que variable de commande,
dans lequel la génération (104) de la trajectoire de guidage optimale comprend en outre la réalisation d'une analyse des coûts sur la base des caractéristiques de performance, et
dans lequel la trajectoire de guidage optimale diminue de façon monotone et se termine à une altitude minimale (68) supérieure à la route du point initial (70) du guidage basé sur la position.
